(19) **Europäisches Patentamt**
**European Patent Office**
**Office européen des brevets**

(11) **EP 3 082 257 B1**

(12) **EUROPEAN PATENT SPECIFICATION**

(45) Date of publication and mention
of the grant of the patent:
**27.06.2018 Bulletin 2018/26**

(51) Int Cl.:
*H03F 1/32* *(2006.01)*  *H03F 1/52* *(2006.01)*
*H03F 3/195* *(2006.01)*  *H03F 3/24* *(2006.01)*
*H04B 1/04* *(2006.01)*

(21) Application number: **15305580.1**

(22) Date of filing: **17.04.2015**

(54) **ANTI SNAPBACK FILTER**

**FILTER MIT RÜCKSCHNAPPSCHUTZ**

**FILTRE ANTI-REBOND**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**19.10.2016 Bulletin 2016/42**

(73) Proprietor: **Alcatel Lucent
91620 Nozay (FR)**

(72) Inventors:
• **Rixain, Michel
91620 NOZAY (FR)**

• **Peyrot, Hervé
91620 NOZAY (FR)**
• **Gascon, Jean-Francois
76260 EU (FR)**

(74) Representative: **Berthier, Karine
Alcatel-Lucent International
Patent Business
Site Nokia Paris Saclay
Route de Villejust
91620 Nozay (FR)**

(56) References cited:
**US-A1- 2014 146 918    US-A1- 2014 294 119**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

## Field of the Invention

The present invention generally relates to the field of communication networks, in particular to amplification devices for radio communication networks. More particularly, but not exclusively, the present invention relates to amplification devices adapted for being used in a remote radio head, for radiofrequency transmission.

## Background

A generic common failure mode with transistor technology, in particular with LDMOS (Laterally Diffused Metal Oxide Semiconductor) technology, has appeared inside the actual power amplifiers, especially at the highest power levels and across transistors suppliers. Over the last years several amplifiers have experienced similar failures across various manufacturers, geographic areas, and communication standards. The common point of failure has been the high power transistors in the power amplifiers. The failure analyses conducted by the transistor manufacturers indicate that the predominant root cause of failure is the presence of harmful signals in the radiofrequency input to the power amplifier. All standard generations, 2G, 3G, 4G are impacted. However the smart mobile phone introduction has accelerated the number of failures. These harmful signals are peak signals whose rise time is less than or equal to 10 ns. Some of these harmful signals are notably under the form of spikes, and cause the occurrence of a destructive phenomenon in the transistors, known as a snapback phenomenon. Symptoms of such a phenomenon are loss of gain and presence of a shunt path in the gate-source circuit of the transistor. Spikes are the physical phenomena of a mathematical function called Dirac delta.

This harmful impact of such a snapback phenomenon in the transistors is known as a problem for a long time. It is likely that a switching mode will soon be introduced within the power amplifiers, for example for the new mobile format 5G, and hence that the power supplies will have a high speed of the voltage switching. It is largely predictable that some cautions will then have to be taken to avoid similar failures for LDMOS and the other transistor technologies like VDMOS (Vertically Diffused Metal Oxide Semiconductor), CMOS (Complementary metal oxide semi-conductor), NMOS (N-type metal-oxide-semiconductor), GaAs (Gallium Arsenide) and GaN (Gallium Nitride).

The source of the damaging input can be any part of the radio or of digital system prior to the input of the high power stage of the amplifier including the base band, the transmission radio, all algorithms and digital to analogue conversion. There are many variables that interact with each other in this issue including device characteristics, power amplifier design, radio system design, and the operating environment.

Digital-to-analogue conversion by any of a variety of methods may be the source of harmful signals. In some cases the harmful signals have been generated by the signal-processing software in the base station. Digital PreDistortion (DPD) algorithms have also been implicated as a cause of these inputs. One known cause of these failures is the introduction of fast-rising pulses from the radio or other sources into the input of the high power stage of the amplifier. This harmful pulsed signal type can be produced by base station software, including DPD algorithms, 3GPP Release 99, High Speed Downlink Packet Algorithms and LTE (Long Term Evolution). Some experimental tests have shown that a specific source of harmful signals in the transmitter chain was a digitally-controlled attenuator in generator. This attenuator in generator has been shown to enter a low attenuation state at power on, and to produce high power bursts during certain state transitions.

Some solutions exist for reducing the impact of such harmful signals in the predistortion loop of an amplification device comprising a power amplifier, so as to avoid failure of the power amplifier.

For example, one known solution consists in reducing the drain voltage of transistor by 1 or 2 Volts. However, one drawback of this solution is that all amplification devices and radiofrequency transmitters impacted and situated in the same geographic area have to be returned to manufactory to set the new voltage or to change the supply power. Besides, reducing the drain voltage decreases the power capabilities of the devices. As a consequence, the amplification devices performances will be reduced. A main damage caused by this reduction in performances lies in a degradation of the amplification linearity. As a result, the modified devices will have to be tested again and some transistors will have to be replaced up the remote radio head measures meet the linearity specifications. However, this solution is provisional because in winter, at low temperature, transistors are more fragile and can break. US20140146918 discloses an amplification device of the prior art.

## Summary

So an object of this invention is to provide a perennial solution for reducing the impact of harmful signals on the power amplifier of an amplification device, so as to avoid failure of said power amplifier, while not decreasing the power capabilities of the amplification device and not disturbing the amplification linearity.

The present invention provides an amplification device according to the appended claims.

The amplification device may include additional characteristics considered separately or combined, and notably:

- said at least one semiconductor electronic component is an analog radiofrequency semiconductor electronic component or a switching radiofrequency semiconductor electronic component;

- the filtering means are adapted to have an upper cutoff frequency whose value is given by a sum between a value of a highest frequency of a frequency range of the input signal and a value of a frequency width of the input signal times a numerical value, said numerical value being equal to 1 or 2 ;
- the filtering means are adapted to have a predefined bandwidth $B_{W19}$, in particular a -19 dB bandwidth, which satisfies formula: $B_{w19} = F_1 - \Delta_f + (2 - K_1) \times B_{sig}$, wherein $F_1$ is a frequency value, in particular substantially equal to 200 MHz, $\Delta_f$ is the frequency range of the input signal, $K_1$ is a numerical value between 1 and 3, and $B_{sig}$ is the frequency width of the input signal ;
- the filtering means are adapted to have a passband ripple whose value is more than or equal to -0.5 dB ;
- the filtering means are adapted to have insertion losses whose value is more than or equal to -3 dB ;
- the filtering means are adapted to have a return loss whose value is less than or equal to 10 dB ;
- the at least one semiconductor electronic component is a bipolar transistor or an electronic field effect transistor;
- the power amplifier further comprises at least one capacitor, said at least one capacitor being connected to a gate or to a drain of the electronic field effect transistor;
- the filtering means comprise a digital or analog polynomial filter, for example a polynomial Chebyshev filter type ;
- the filtering means comprise a stripline filter or a dielectric filter or a cavity filter;
- the predistortion module is adapted to receive a feedback signal from an output of the power amplifier, to determine a transmission characteristic of the power amplifier from the received feedback signal, and to pre-distort the input signal according to said determined transmission characteristic of the power amplifier;
- said predefined time value is equal to 10 ns.

According to a second aspect, the present invention provides a radiofrequency transmitter comprising an amplification device as set forth above.

The radiofrequency transmitter may include the additional characteristic wherein the filtering means of the amplification device are adapted to have an enlarged bandwidth compared to an effective bandwidth of the radiofrequency transmitter, said enlarged bandwidth encompassing said effective bandwidth.

**Brief Description of the Figures**

Some embodiments of apparatus and/or methods in accordance with embodiments of the present invention are now described, by way of example only, and with reference to the accompanying drawings, in which :

- The Figure 1 schematically and functionally illustrates a radiofrequency transmitter comprising an amplification device according to the present invention,
- The Figure 2 schematically and functionally illustrates the amplification device of Figure 1 according to a first embodiment, said amplification device comprising a predistortion module providing a predistorded output signal, and means for filtering the predistorded output signal,
- The Figure 3 is a Bode diagram illustrating the transfer function of the filtering means of Figure 2,
- The Figure 4 is a simulated timing diagram illustrating a first unfiltered signal comprising peak signals, said first signal being provided by the predistortion module of Figure 2, and a second signal corresponding to the first signal which is filtered by a digital polynomial filter of the filtering means of Figure 2,
- The Figure 5 is a simulated frequency diagram illustrating a first unfiltered signal comprising peak signals, said first signal being provided by the predistortion module of Figure 2, and a second signal corresponding to the first signal which is filtered by an analog polynomial filter of the filtering means of Figure 2,
- The Figure 6 is a simulated timing diagram illustrating a first unfiltered signal causing the peak signals of the first unfiltered signal of Figure 6, and a second signal corresponding to the first signal which is filtered by an analog polynomial filter of the filtering means of Figure 2,
- The Figure 7 is a perspective view of the filtering means of Figure 2 according to a particular embodiment,
- The Figures 8 and 9 are top views of the filtering means of Figure 2 according to other alternative embodiments.

**Description of Embodiments**

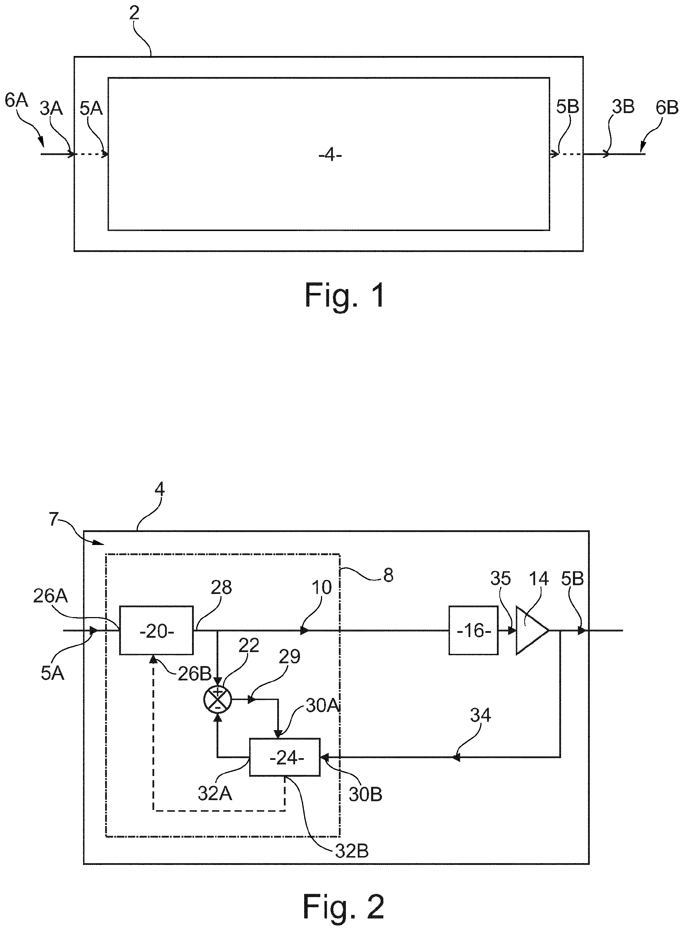

Figure 1 shows a radiofrequency transmitter 2. The radiofrequency transmitter 2 is for example part of a remote radio head used as a communication relay in a communication network, for example a mobile communication network. The radiofrequency transmitter 2 comprises an amplification device 4 intended to provide the power required for the transmission of radio waves within this communication network. The radiofrequency transmitter 2 is adapted to receive a digital input signal 3A, from a first wired or wireless communication link 6A. The radiofrequency transmitter 2 is further adapted to provide an amplified analog output signal 3B, on a second wired or wireless communication link 6B. The received input signal 5A is for example a W-CDMA (Wideband Code Division Multiple Access), a LTE (Long-Term Evolution), a 2G, 3G, 4G, or a radio relay signal.

The amplification device 4 is adapted to receive an input signal 5A and to provide an output signal 5B.

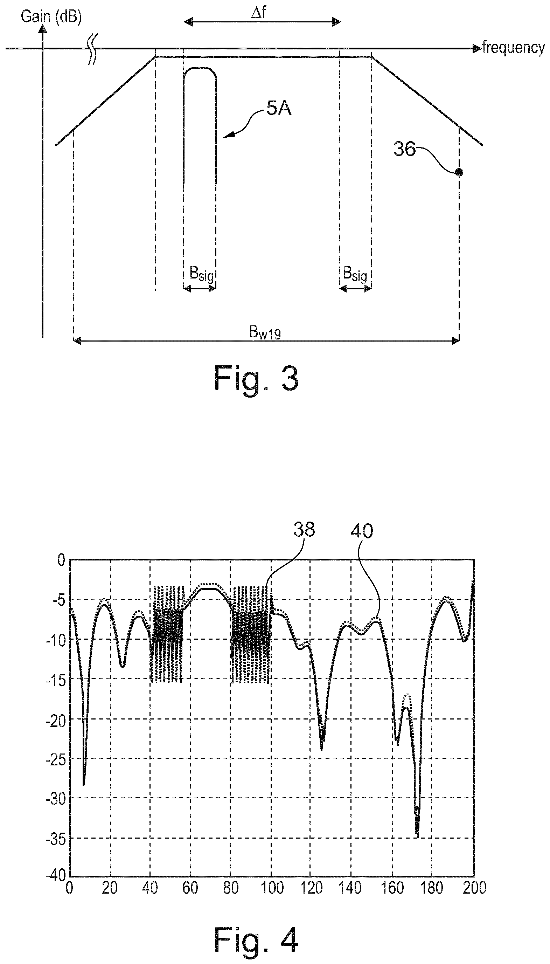

The radiofrequency transmitter 2 includes, upstream of the amplification device 4, a digital processing stage which is not shown on Figure 1 for clarity reasons. The radiofrequency transmitter 2 further includes, downstream of the amplification device 4, a radiofrequency duplexer and an antenna which are not shown on Figure 1 for clarity reasons. The received input signal 5A has a frequency width Bsig, as shown in Figure 3.

As shown in Figure 2, the amplification device 4 comprises a predistortion loop 7. The predistortion loop 7 includes a predistortion module 8 adapted to provide a predistorded output signal 10 from the received input signal 5A, a power amplifier 14, and means 16 for filtering the predistorded output signal 10.

In the exemplary embodiment of Figure 2, which is a synoptic and functional view, the predistortion module 8 is a digital predistortion module which comprises a predistording functional block 20, a subtractor 22 and a digital predistorder 24. The predistortion module 8 is for example integrated within a FPGA (Field-Programmable Gate Array) or within an ASIC (Application-Specific Integrated Circuit).

The predistording functional block 20 has a first input 26A and a second input 26B. It further has an output 28 connected to the input of the filtering means 16. The predistording functional block 20 is adapted to receive the input signal 5A on its first input 26A, and to provide the predistorded output signal 10 on its output 28. In this exemplary embodiment of Figure 2, the predistorded output signal 10 is a digital signal.

The non-inverting input of the subtractor 22 is connected to the output 28 of the predistording functional block 20. The output of the substractor 22 is adapted to provide a digital, time discrete error signal 29.

The digital predistorder 24 has a first input 30A, a second input 30B, a first output 32A and a second output 32B. The first input 30A is connected to the output of the subtractor 22. The second input 30B is connected to the output of the power amplifier 14. The first output 32A is connected to the inverting input of the subtractor 22. The second output 32B is connected to the second input 26B of the predistording functional block 20.

The digital predistorder 24 is adapted to receive, on its second input 30B, a feedback signal 34 from the output of the power amplifier 14.

The feedback signal 34 is an analog and down-converted scaled version of the amplified output signal 5B. The feedback signal 34 is digitized by an analog-to-digital converter before being applied on the second input 30B, such a converter not being shown on Figure 2 for clarity reasons.

The time discrete error signal 29 is calculated from the predistorded output signal 10 and the feedback signal 34.

According to this exemplary embodiment of Figure 2, the predistortion module 8 is adapted to receive a feedback signal 34 from the output of the power amplifier 14, to determine a transmission characteristic of the power amplifier 14 from the received feedback signal 34, and to predistord the received input signal 5A according to the determined characteristic of the power amplifier 14.

More precisely, the predistortion module 8 is adapted to perform multiple iterations in order to determine the transmission characteristic of the power amplifier 14. When the predistortion module 8 has not yet reached a state where the transmission characteristic of the power amplifier 14 have been determined, the time discrete error signal 29 includes spectral portions related to the nonlinearities of the power amplifier 14. After some iterations within the predistortion loop 7, when the transmission characteristic of the power amplifier 14 have been determined, the value of the time discrete error signal 29 is almost zero and the predistording functional block 20 predistords the input signal 5A according to the determined characteristic of the power amplifier 14.

In this exemplary embodiment of Figure 2, the predistortion loop 7 forms a digital indirect learning predistortion loop. This allows to avoid distortion of the input signal 5A by the power amplifier 14, by determining the transmission characteristic of the power amplifier 14 during use of the amplification device 4, and by compensating upstream the effects of the nonlinearities of the power amplifier 14. Alternatively, the predistortion loop 7 forms a direct learning predistortion loop.

The power amplifier 14 is adapted to provide the amplified output signal 5B. The power amplifier 14 comprises at least one semiconductor electronic component.

In the exemplary embodiment of Figure 2, the power amplifier 14 is an non-switched amplifier. In this exemplary embodiment, the or each semiconductor electronic component is an analog radiofrequency component. In a variant not shown in the drawings, the power amplifier 14 is a switched amplifier and the or each semiconductor electronic component is a switching electronic component.

The or each semiconductor electronic component may be a transistor, for example a bipolar transistor or a field effect transistor. In a particular exemplary embodiment, the or each semiconductor electronic component is an electronic field effect transistor, for example a LDMOS transistor. Alternatively, the or each electronic field effect transistor may be chosen from the non-limiting group consisting of: a VDMOS transistor, a CMOS transistor, a NMOS transistor, a PMOS transistor, a GaAs transistor and a GaN transistor. Preferably, according to this particular embodiment, the power amplifier 14 further comprises at least one capacitor connected to a gate or a drain of the or one of the electronic field effect transistor(s). This feature allows to further enhance the protection of the field effect transistors by the filtering means 16, such a protection being detailed below.

The filtering means 16 are connected between the predistortion module 8 and the power amplifier 14, and are adapted to provide a filtered signal 35 to the power amplifier 14.

In the particular exemplary embodiment of Figure 2, the filtering means 16 are analog filtering means and comprise an analog polynomial filter, for example a polynomial Chebyshev filter type. In this exemplary embodiment of Figure 2, a digital-to-analog converter, not shown in the Figure for clarity reasons, is arranged between the predistortion module 8 and the power amplifier 14. The digital-to-analog converter allows to convert the predistorded output signal 10 to an analog signal before it being processed by the filtering means 16. In a particular alternative not shown in the drawings, the filtering means 16 are digital filtering means. According to this alternative, the filtering means 16 are for example integrated within the same FPGA or ASIC as that of the predistortion module 8, and a digital-to-analog converter is arranged between the filtering means 16 and the power amplifier 14. According to an exemplary embodiment of this particular alternative, the filtering means 16 comprise a digital polynomial filter, for example a polynomial Chebyshev filter type.

The filtering means 16 are configured to increase the rise time of any peak signal whose initial rise time is less than or equal to a predefined time value, and which is contained in the predistorded output signal 10, and to provide the resulting peak signal within the filtered signal 35 so as to protect the or each semiconductor electronic component. The or each resulting peak signal has a rise time greater than said predefined time value. In the particular case wherein the harmful peak signal is a spike, i.e. the harmful peak signal has a rise time less than or equal to a predefined time value of 10 ns, increasing the rise time of such a signal has the advantageous effect of cancelling the spike within the filtered signal 35. Thus, the filtering means 16 are advantageously configured to attenuate or cancel every peak signal having an initial rise time less than or equal to 10 ns, whatever its origin before the power amplifier 14 (modem, channel coding, base band, transmission part, predistortion module and so on). This allows to reduce the impact of such harmful peak signals on the power amplifier 14, while not decreasing the power capabilities of the amplification device 4 and not disturbing the amplification linearity, as will be detailed below.

According to a preferred embodiment illustrated in Figure 3, the filtering means 16 are adapted to have an enlarged bandwidth compared to an effective bandwidth $\Delta_f$ of the radiofrequency transmitter 2. By "enlarged bandwidth" it is meant in the following that the bandwidth of the filtering means 16 encompass the effective bandwidth $\Delta_f$ of the radiofrequency transmitter 2.

Preferably, according to this preferred embodiment, the filtering means 16 are adapted to have an upper cutoff frequency whose value is given by the sum between the value of the highest frequency of the frequency range $\Delta_f$ of the received input signal 5A and the frequency width $B_{sig}$ of the input signal 5A times a numerical value. This numerical value is equal to 1 or 2. This allows to ensure that digital predistorder 24 gets a right image of distortion. More precisely, when the numerical value is equal to 1, as is the case in the embodiment of Figure 3, such a design for the filtering means 16 allows not deforming the 3th order InterModulation (IMD3) component of the signal 10 predistorded by the predistortion module 8. When the numerical value is equal to 2, such a design for the filtering means 16 allows not deforming the IMD3 component and the 5th order InterModulation (IMD5) component of the predistorded signal 10.

Since the filtering means 16 are included in the predistortion loop 7, the filtering means 16 must not attenuate the spectral portions related to the nonlinearities of the power amplifier 14 in the extreme cases where the received signal 5A is situated at the lowest or at the highest frequency of the effective bandwidth $\Delta_f$ of the radiofrequency transmitter 2. In the exemplary embodiment of Figure 3 the received signal 5A is situated at the lowest frequency of the effective bandwidth $\Delta_f$ of the radiofrequency transmitter 2. In this exemplary embodiment, in order to satisfy the above-mentioned constraint, the filtering means 16 are adapted to have a predefined bandwidth $B_{W19}$, in particular a -19 dB bandwidth, which satisfies formula :

$$ B_{w19} = F_1 - \Delta_f + (2 - K_1) \times B_{sig} \quad (1) $$

$F_1$ is a frequency value, in particular substantially equal to 200 MHz. The choice of this particular value for F1 allows to attenuate any peak signal contained in the predistorded output signal 10, whose rise time is less than or equal to 5 ns. $K_1$ is a numerical value between 1 and 3. When the numerical value $K_1$ is equal to 1, such a design for the filtering means 16 allows not deforming the IMD3 component of the signal 10 predistorded by the predistortion module 8. When the numerical value $K_1$ is equal to 3, such a design for the filtering means 16 allows not deforming the IMD3 component and the IMD5 component of the predistorded signal 10.

Preferably, the filtering means 16 are adapted to have a passband ripple whose value is more than or equal to -0.5 dB. This ensures that the amplitude variation versus frequency is in the range of digital equalization.

Preferably again, the filtering means 16 are adapted to have insertion losses whose absolute value is more than or equal to -3 dB. This allows to ensure that the reserve gain for transmission is sufficient.

Preferably again, the filtering means 16 are adapted to have a return loss whose absolute value is less than or equal to 10 dB. This allows to ensure that the filtering means 16 have a satisfactory adaptation to the impedance of the system.

The operation of the amplification device 4 will now be described with reference to Figures 2 to 6.

It is assumed that the filtering means 16 comprise an analog polynomial Chebyshev filter type. It is further assumed that the input signal 5A comprises several peak signals whose rise time is less than or equal to 10 ns, for example substantially equal to 5 ns. A point 36 represents each of these peak signals in the Bode diagram of Figure 3.

Firstly, the predistording functional block 20 receives the input signal 5A on its first input 26A, and provides the predistorded output signal 10 on its output 28. In the exemplary embodiment of Figure 2, the predistorded output signal 10 is a digital signal.

More precisely, the predistording functional block 20 predistords the input signal 5A according to the characteristic of the power amplifier 14, determined previously by the predistortion module 8 via the received feedback signal 34. Consequently, the predistorded output signal 10 comprises the spectral portions related to the nonlinearities of the power amplifier 14.

The predistorded signal 10 is then transmitted to the filtering means 16. Thanks to their above-mentioned configuration, the filtering means 16 attenuate sufficiently each peak signal contained in the predistorded signal 10 to protect the or each semiconductor electronic component of the power amplifier 14. More precisely, the filtering means 16 increase the rise time of each peak signal contained in the predistorded signal 10, and provide within the filtered signal 35, for each initial peak signal, a resulting peak signal whose rise time is greater than 10 ns, so as to protect the or each semiconductor electronic component. This operation of the filtering means 16 is illustrated in Figures 4 to 6.

Figure 4 is a simulated timing diagram. The curve 38 represents the predistorded output signal 10 over time, and the curve 40 represents the filtered signal 35 over time. It can be seen from Figure 4 that every peak signal contained in the predistorded output signal 10 has been efficiently attenuated by the filtering means 16, since the curve 40 comprises no more peak signals whose rise time is less than or equal to 10 ns. Thus, the or each semiconductor electronic component of the power amplifier 14 is efficiently protected by the filtering means 16.

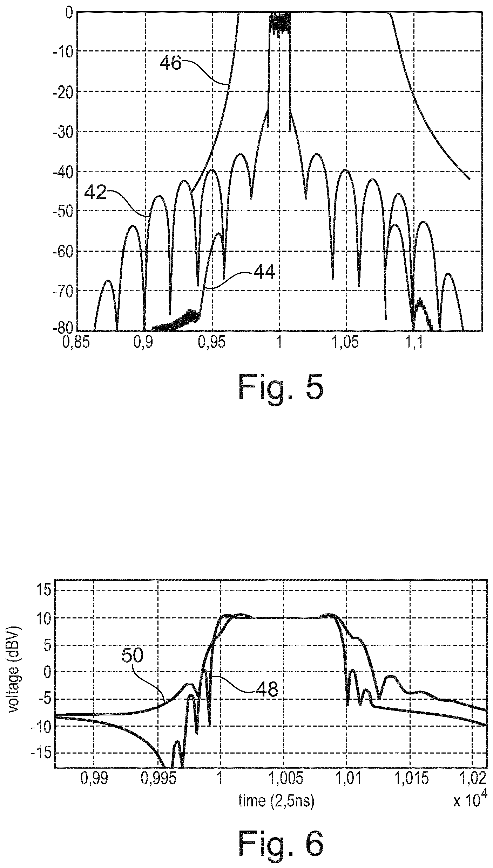

Figure 5 is a simulated frequency diagram. The curve 42 represents the frequency spectrum of the predistorded output signal 10, and the curve 44 represents the frequency spectrum of the filtered signal 35. The curve 46 represents the transfer function of the filtering means 16. From Figure 5 it can be seen how the filtering means 16 modify the frequency spectrum of the predistorded output signal 10. The cardinal sine portions appearing on the curve 42 are due to a particular peak signal contained in the predistorded output signal 10, which is represented in Figure 6. This particular peak signal is a square signal with a strong level.

Figure 6 is a simulated timing diagram, in which the curve 48 represents this undesired square signal over time, and the curve 50 represents the square signal over time, when filtered by the filtering means 16. From Figure 6 it can be seen that the filtering means 16 smoothen the edges of the undesired square signal so that the rise time of this signal increases up to acceptable values, i.e. to values greater than 10 ns. Thus, the or each semiconductor electronic component of the power amplifier 14 is efficiently protected by the filtering means 16.

Besides, some operational tests have been made in which a test bench was configured to generate many peak signals having a rise time less than or equal to 10 ns. The predistortion module 8, the filtering means 16 and the power amplifier 14 have been connected downstream to the test bench. The tests have shown that with the filtering means 16 compliant to the above-mentioned configuration, peak signals having a rise time less than or equal to 10 ns have been detected upstream of the filtering means 16, but that no such peak signal has been detected downstream of the filtering means 16. The characteristic and performances of the semiconductor electronic components such as gain, efficiency, linearity have been checked with success, i.e. no degradation in these parameters was detected. Tests have been repeated with different types of semiconductor electronic components and none of them broke. The same semiconductor electronic components have been tested again without the filtering means 16 and have been destroyed due to the harmful peak signals.

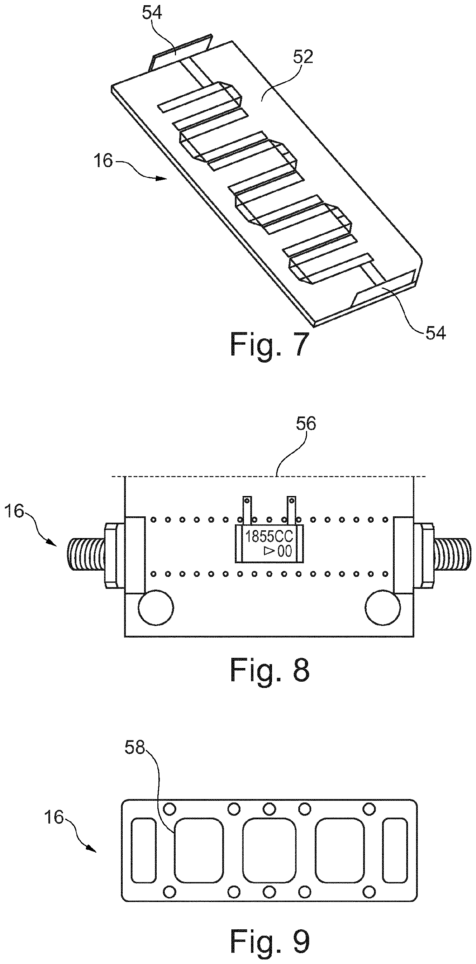

In the exemplary embodiment of Figure 7, the filtering means 16 comprise a stripline filter 52. The stripline filter 52 is a coupled line filter which has two metallic electrodes 54, for example two copper electrodes 54. The use of such a stripline filter for the filtering means 16 allows reducing the design time of the filtering means.

In an alternative embodiment illustrated on Figure 8, the filtering means 16 comprise a dielectric filter 56.

In another alternative embodiment illustrated on Figure 9, the filtering means 16 comprise a cavity filter 58. Such a cavity filter can be easily inserted within a cabinet at the output of the predistortion module 8.

Each of these three embodiments for the filtering means 16, illustrated on Figures 7 to 9, allows providing a low volume for the filtering means. This facilitates the insertion of the filtering means within the amplification device 4, in particular when the amplification device 4 is used as a radiofrequency amplification device.

Thus, the amplification device according to the invention allows reducing the impact of harmful signals on the power amplifier so as to avoid failure of said power amplifier, while not decreasing the power capabilities of the amplification device and not disturbing the amplification linearity.

Moreover, the amplification device according to the invention has the further advantage that the filtering means can be integrated within the device either at the initial design phase of the device, or directly onsite afterwards, without requiring any additional add-on or hardware.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

The description and drawings merely illustrate the principles of the invention.

Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. Amplification device (4) adapted for being used in a radiofrequency transmitter (2), said amplification device (4) comprising a predistortion loop (7), said predistortion loop (7) including:

    • a predistortion module (8), adapted to provide a predistorded output signal (10) from a received input signal (5A),
    • a power amplifier (14), comprising at least one semiconductor electronic component, and
    • means (16) for filtering the predistorded output signal (10), said means (16) being connected between the predistortion module (8) and the power amplifier (14) and being adapted to provide a filtered signal (35) to the power amplifier (14),

    wherein the filtering means (16) are configured to increase the rise time of any peak signal whose initial rise time is less than or equal to a predefined time value, said peak signal being contained in the predistorded output signal (10), and to provide the resulting peak signal within the filtered signal (35) so as to protect the or each semiconductor electronic component, said resulting peak signal having a rise time greater than said predefined time value,
    **characterized in that** the filtering means (16) are adapted to have an upper cutoff frequency whose value is given by a sum of a value of a highest frequency of an effective bandwidth ($\Delta_f$) of the radiofrequency transmitter (2) and a value of a frequency width of the input signal (5A) times a numerical value, said numerical value being equal to 1 or 2.

2. Amplification device (4) according to claim 1, wherein said at least one semiconductor electronic component is an analog radiofrequency semiconductor electronic component or a switching radiofrequency semiconductor electronic component.

3. Amplification device (4) according to any one of the preceding claims, wherein the filtering means (16) are adapted to have a predefined bandwidth $B_{W19}$, in particular a -19 dB bandwidth, which satisfies formula: $B_{w19} = F_1 - \Delta_f + (2 - K_1) \times B_{sig}$, wherein $F_1$ is a frequency value, in particular substantially equal to 200 MHz, $\Delta_f$ is the effective bandwidth of the radiofrequency transmitter (2), $K_1$ is a numerical value between 1 and 3, and $B_{sig}$ is the frequency width of the input signal (5A).

4. Amplification device (4) according to any one of the preceding claims, wherein the filtering means (16) are adapted to have a passband ripple whose value is more than or equal to -0.5 dB.

5. Amplification device (4) according to any one of the preceding claims, wherein the filtering means (16) are adapted to have insertion losses whose value is more than or equal to -3 dB.

6. Amplification device (4) according to any one of the preceding claims, wherein the filtering means (16) are adapted to have a return loss whose value is less than or equal to 10 dB.

7. Amplification device (4) according to any one of the preceding claims, wherein the at least one semiconductor electronic component is a bipolar transistor or an electronic field effect transistor.

8. Amplification device (4) according to claim 7, wherein the power amplifier (14) further comprises at least one capacitor, said at least one capacitor being connected to a gate or to a drain of the electronic field effect transistor.

9. Amplification device (4) according to any one of the preceding claims, wherein the filtering means (16) comprise a digital or analog polynomial filter, for example a polynomial Chebyshev filter type.

10. Amplification device (4) according to any one of the preceding claims, wherein the filtering means (16) comprise a stripline filter (52) or a dielectric filter (56) or a cavity filter (58).

11. Amplification device (4) according to any one of the preceding claims, wherein the predistortion module (8) is adapted to receive a feedback signal (34) from an output of the power amplifier (14), to determine a transmission characteristic of the power amplifier (14) from the received feedback signal (34), and to pre-distort the input signal (5A) according to said determined transmission characteristic of the power amplifier (14).

12. Amplification device (4) according to any one of the preceding claims, wherein said predefined time value is equal to 10 ns.

13. Radiofrequency transmitter (2) comprising an amplification device (4) according to any of the preceding claims.

14. Radiofrequency transmitter according to claim 13, wherein the filtering means (16) of the amplification device (4) are adapted to have an enlarged bandwidth compared to an effective bandwidth of the radiofrequency transmitter, said enlarged bandwidth encompassing said effective bandwidth.


**Patentansprüche**

1. Verstärkungsvorrichtung (4), ausgelegt für die Verwendung in einem Radiofrequenzsender (2), wobei besagte Verstärkungsvorrichtung (4) umfasst eine Vorverzerrungsschleife (7), wobei besagte Vorverzerrungsschleife (7) einschließt:

   • ein Vorverzerrungsmodul (8), ausgelegt zum Bereitstellen eines vorverzerrten Ausgangssignals (10) aus einem empfangenen Eingangssignal (5A),
   • einen Leistungsverstärker (14), umfassend mindestens eine elektronische Halbleiterkomponente und
   • Mittel (16) zum Filtern des vorverzerrten Ausgangssignals (10), wobei besagte Mittel (16) zwischen dem Vorverzerrungsmodul (8) und dem Leistungsverstärker (14) angeschlossen sind und ausgelegt sind zum Bereitstellen eines gefilterten Signals (35) zum Leistungsverstärker (14),

   wobei die Filtermittel (16) konfiguriert sind zum Erhöhen der Anstiegszeit eines beliebigen Peak-Signals, dessen ursprüngliche Anstiegszeit geringer oder gleich ist einem vordefinierten Zeitwert, wobei besagtes Peak-Signal enthalten ist in dem vorverzerrten Ausgangssignal (10) und zum Bereitstellen des resultierenden Peak-Signals innerhalb des gefilterten Signals (35), um die oder jede beliebige elektronische Halbleiterkomponente zu schützen, wobei besagtes resultierendes Peak-Signal eine Anstiegszeit aufweist, die größer ist als besagter vordefinierter Zeitwert, **dadurch gekennzeichnet, dass** die Filtermittel (16) ausgelegt sind, eine obere Cutoff-Frequenz aufzuweisen, deren Wert gegeben ist durch eine Summe eines Wertes der höchsten Frequenz einer effektiven Bandbreite ($\Delta_f$) des Radiofrequenzsenders (2) und eines Wertes einer Frequenzbreite des Eingangssignals (5A) multipliziert mit einem numerischen Wert, wobei besagter numerischer Wert gleich 1 oder 2 ist.

2. Verstärkungsvorrichtung (4) nach Anspruch 1, wobei besagte mindestens eine elektronische Halbleiterkomponente eine analoge elektronische Radiofrequenzhalbleiterkomponente oder eine elektronische Radiofrequenzumschalt-Halbleiterkomponente ist.

3. Verstärkungsvorrichtung (4) nach einem beliebigen der vorhergehenden Ansprüche, wobei die Filtermittel (16) ausgelegt sind, eine vordefinierte Bandbreite $B_{W19}$ aufzuweisen, insbesondere eine -19 dB Bandbreite, welche die folgende Formel erfüllt:
$B_{W19} = F_1 - \Delta_f + (2 - K_1) \times B_{sig}$, wobei $F_1$ ein Frequenzwert ist, insbesondere im Wesentlichen gleich 200 MHz, $\Delta_f$ die effektive Bandbreite des Radiofrequenzsenders (2) ist, $K_1$ ein numerischer Wert zwischen 1 und 3 und $B_{sig}$ die Frequenzbreite des Eingangssignals (5A).

4. Verstärkungsvorrichtung (4) nach einem beliebigen der vorhergehenden Ansprüche, wobei die Filtermittel (16) ausgelegt sind, eine Passbandwelligkeit aufzuweisen, deren Wert größer oder gleich -0,5 dB ist.

5. Verstärkungsvorrichtung (4) nach einem beliebigen der vorhergehenden Ansprüche, wobei die Filtermittel (16) ausgelegt sind, Insertionsverluste aufzuweisen, deren Wert größer oder gleich -3 dB ist.

6. Verstärkungsvorrichtung (4) nach einem beliebigen der vorhergehenden Ansprüche, wobei die Filtermittel (16) ausgelegt sind, einen Rückgabeverlust aufzuweisen, dessen Wert kleiner oder gleich 10 dB ist.

7. Verstärkungsvorrichtung (4) nach einem beliebigen der vorhergehenden Ansprüche, wobei die mindestens eine elektronische Halbleiterkomponente ein bipolarer Transistor oder ein Transistor mit elektronischem Feldeffekt ist.

8. Verstärkungsvorrichtung (4) nach Anspruch 7, wobei der Leistungsverstärker (14) weiterhin umfasst einen Kondensator, wobei besagter mindestens eine Kondensator mit einem Gate verbunden ist oder mit einem Drain des Transistors mit elektronischem Feldeffekt.

9. Verstärkungsvorrichtung (4) nach einem beliebigen der vorhergehenden Ansprüche, wobei die Filtermittel (16) umfassen einen digitalen oder analogen Polynomfilter, zum Beispiel einen polynomiellen Filter vom Chebyshev-Typ.

**10.** Verstärkungsvorrichtung (4) nach einem beliebigen der vorhergehenden Ansprüche, wobei die Filtermittel (16) umfassen einen Stripline-Filter (52) oder einen dielektrischen Filter (56) oder einen Hohlraumfilter (58).

**11.** Verstärkungsvorrichtung (4) nach einem beliebigen der vorhergehenden Ansprüche, wobei das Vorzerrungsmodul (8) ausgelegt ist zum Empfangen eines Feedback-Signals (34) von einem Ausgang des Leistungsverstärkers (14) zum Bestimmen einer Sendecharakteristik des Leistungsverstärkers (14) von dem empfangenen Feedback-Signal (34) und zum Vorverzerren des Eingangssignals (5A) gemäß besagter bestimmter Sendecharakteristik des Leistungsverstärkers (14).

**12.** Verstärkungsvorrichtung (4) nach einem beliebigen der vorhergehenden Ansprüche, wobei besagter vordefinierter Zeitwert gleich 10 ns ist.

**13.** Radiofrequenzsender (2), umfassend eine Verstärkungsvorrichtung (4) nach einem beliebigen der vorhergehenden Ansprüche.

**14.** Radiofrequenzsender nach Anspruch 13, wobei die Filtermittel (16) der Verstärkungsvorrichtung (4) ausgelegt sind, eine vergrößerte Bandbreite aufzuweisen im Vergleich zu einer effektiven Bandbreite des Radiofrequenzsenders, wobei besagte vergrößerte Bandbreite besagte effektive Bandbreite umfasst.

**Revendications**

**1.** Dispositif d'amplification (4) adapté pour être utilisé dans un transmetteur radiofréquence (2), ledit dispositif d'amplification (4) comprenant une boucle de pré-distorsion (7), ladite boucle de pré-distorsion (7) incluant :

• un module de pré-distorsion (8), adapté pour fournir un signal de sortie préalablement distordu (10) à partir d'un signal d'entrée reçu (5A),
• un amplificateur de puissance (14), comprenant au moins un composant électronique semiconducteur, et
• un moyen (16) de filtrage du signal de sortie préalablement distordu (10), ledit moyen (16) étant connecté entre le module de pré-distorsion (8) et l'amplificateur de puissance (14) et étant adapté pour fournir un signal filtré (35) à l'amplificateur de puissance (14),

dans lequel le moyen de filtrage (16) est configuré pour augmenter le temps de montée d'un quelconque signal de pic dont le temps de montée initial est inférieur ou égal à une valeur de temps prédéfinie, ledit signal de pic étant contenu dans le signal de sortie préalablement distordu (10), et pour fournir le signal de pic résultant à l'intérieur du signal filtré (35) afin de
protéger le ou chaque composant électronique semiconducteur, ledit signal de pic résultant présentant un temps de montée supérieur à ladite valeur de temps prédéfinie,
**caractérisé en ce que** le moyen de filtrage (16) est adapté pour présenter une fréquence limite supérieure dont la valeur est donnée par une somme d'une valeur d'une fréquence la plus haute d'une largeur de bande ($\Delta_f$) effective du transmetteur radiofréquence (2) et d'une valeur d'une largeur de fréquence du signal d'entrée (5A) multipliée par une valeur numérique, ladite valeur numérique étant égale à 1 ou 2.

**2.** Dispositif d'amplification (4) selon la revendication 1, dans lequel ledit au moins un composant électronique semiconducteur est un composant électronique semiconducteur radiofréquence analogique ou un composant électronique semiconducteur radiofréquence de commutation.

**3.** Dispositif d'amplification (4) selon l'une quelconque des revendications précédentes, dans lequel le moyen de filtrage (16) est adapté pour présenter une largeur de bande prédéfinie $B_{w19}$, en particulier une largeur de bande de -19 dB, qui satisfait la formule : $B_{w19} = F_1 - \Delta_f + (2 - K_1) \times B_{sig}$, dans laquelle $F_1$ est une valeur de fréquence, en particulier sensiblement égale à 200 MHz, $\Delta_f$ est la largeur de bande effective du transmetteur radiofréquence (2), $K_1$ est une valeur numérique entre 1 et 3, et $B_{sig}$ est la largeur de fréquence du signal d'entrée (5A).

**4.** Dispositif d'amplification (4) selon l'une quelconque des revendications précédentes, dans lequel le moyen de filtrage (16) est adapté pour présenter une ondulation de bande passante dont la valeur est supérieure ou égale à -0,5 dB.

**5.** Dispositif d'amplification (4) selon l'une quelconque des revendications précédentes, dans lequel le moyen de filtrage (16) est adapté pour présenter des pertes d'insertion dont la valeur est supérieure ou égale à -3 dB.

**6.** Dispositif d'amplification (4) selon l'une quelconque des revendications précédentes, dans lequel le moyen de filtrage (16) est adapté pour présenter une perte de retour dont la valeur est inférieure ou égale à 10 dB.

**7.** Dispositif d'amplification (4) selon l'une quelconque des revendications précédentes, dans lequel l'au moins un composant électronique semiconducteur est un transistor bipolaire ou un transistor à effet de champ électronique.

**8.** Dispositif d'amplification (4) selon la revendication 7, dans lequel l'amplificateur de puissance (14) comprend en outre au moins un condensateur, ledit au moins un condensateur étant connecté à une grille ou à un drain du transistor à effet de champ électronique.

**9.** Dispositif d'amplification (4) selon l'une quelconque des revendications précédentes, dans lequel le moyen de filtrage (16) comprend un filtre polynomial numérique ou analogique, par exemple un type de filtre de Chebyshev polynomial.

**10.** Dispositif d'amplification (4) selon l'une quelconque des revendications précédentes, dans lequel le moyen de filtrage (16) comprend un filtre microruban (52) ou un filtre diélectrique (56) ou un filtre à cavité (58).

**11.** Dispositif d'amplification (4) selon l'une quelconque des revendications précédentes, dans lequel le module de pré-distorsion (8) est adapté pour recevoir un signal de retour (34) à partir d'une sortie de l'amplificateur de puissance (14), pour déterminer une caractéristique de transmission de l'amplificateur de puissance (14) à partir du signal de retour (34) reçu, et pour pré-distordre le signal d'entrée (5A) selon ladite caractéristique de transmission déterminée de l'amplificateur de puissance (14).

**12.** Dispositif d'amplification (4) selon l'une quelconque des revendications précédentes, dans lequel ladite valeur de temps prédéfinie est égale à 10 ns.

**13.** Transmetteur radiofréquence (2) comprenant un dispositif d'amplification (4) selon l'une quelconque des revendications précédentes.

**14.** Transmetteur radiofréquence selon la revendication 13, dans lequel le moyen de filtrage (16) du dispositif d'amplification (4) est adapté pour présenter une largeur de bande élargie comparée à une largeur de bande effective du transmetteur radiofréquence, ladite largeur de bande élargie englobant ladite largeur de bande effective.

Fig. 1

Fig. 2

Fig. 3

Fig. 4

Fig. 5

Fig. 6

54

52

16

Fig. 7

54

56

16

1855CC
▷ 00

Fig. 8

58

16

Fig. 9

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20140146918 A